Europäisches Patentamt

(19) European Patent Office

Office européen des brevets

(11) **EP 0 995 083 B1**

(12) **EUROPÄISCHE PATENTSCHRIFT**

(45) Veröffentlichungstag und Bekanntmachung des Hinweises auf die Patenterteilung:
**20.02.2002 Patentblatt 2002/08**

(21) Anmeldenummer: **97948673.5**

(22) Anmeldetag: **24.12.1997**

(51) Int Cl.[7]: **G01F 23/26**

(86) Internationale Anmeldenummer:
**PCT/CH97/00483**

(87) Internationale Veröffentlichungsnummer:
**WO 98/33044 (30.07.1998 Gazette 1998/30)**

(54) **KAPAZITIVER FÜLLSTANDSSENSOR MIT OPTIMIERTER ELEKTRODENGEOMETRIE**

CAPACITATIVE LEVEL DETECTOR WITH OPTIMIZED ELECTRODE GEOMETRY

DETECTEUR DE NIVEAU CAPACITIF A GEOMETRIE D'ELECTRODES OPTIMISEE

(84) Benannte Vertragsstaaten:
**DE GB**

(30) Priorität: **28.01.1997 DE 19704975**
**29.03.1997 DE 19713267**

(43) Veröffentlichungstag der Anmeldung:
**26.04.2000 Patentblatt 2000/17**

(73) Patentinhaber: **ABB RESEARCH LTD.**
**8050 Zürich (CH)**

(72) Erfinder:
 • **BYATT, Anthony**
  **CH-5313 Klingnau (CH)**
 • **CHRISTEN, Thomas**
  **CH-5300 Turgi (CH)**

 • **KLEINER, Thomas**
  **CH-5416 Nussbaumen (CH)**
 • **MATTER, Daniel**
  **CH-5200 Brugg (CH)**
 • **RUEEGG, Walter**
  **CH-5304 Endingen (CH)**

(74) Vertreter: **ABB Patent Attorneys**
**c/o ABB Business Services Ltd, Intellectual**
**Property (SLE-I), Haselstrasse 16/699**
**5401 Baden (CH)**

(56) Entgegenhaltungen:
**EP-A- 0 149 279     EP-A- 0 538 182**
**WO-A-92/21944**

**Beschreibung**

**TECHNISCHES GEBIET**

Die Erfindung bezieht sich auf das Gebiet der Füllstandsanzeigen. Sie geht aus von einem kapazitiven Füllstandssensor nach dem Oberbegriff des Anspruchs 1.

**STAND DER TECHNIK**

Im Stand der Technik sind eine Vielzahl von Vorrichtungen zur Bestimmung des Füllstandes eines Behälters bekannt, die auf sehr unterschiedlichen physikalischen Messprinzipien beruhen. Diese umfassen elektrische (kapazitive oder resistive) und optische Methoden, Radarreflexionsmethoden, Ultraschall-Laufzeitmethoden sowie Gammaabsorptionsmethoden.

Bei der Offshore-Erdölförderung werden sog. Separationstanks eingesetzt, in welchen die bei der Bohrung bzw. Förderung auftretenden verschiedenen Phasen (Sand, Wasser, Öl und Gas) aufgrund ihrer Dichteunterschiede separiert und in getrennten Leitungssystemen abgeführt werden. Es ist dabei sehr wichtig, die Höhe der Trennschicht zwischen Wasser und Oel zu kennen, um am Tank die Ablassventile für die beiden Medien kontrolliert öffnen und schliessen zu können. Hierzu werden zuverlässige Füllstandsmessgeräte benötigt. Funktioniert ein solches Füllstandsmessgerät nicht oder nicht richtig, kann z. B. Öl in den Wasserauslass geraten und grosse Umweltbelastungen und Kosten verursachen.

Neuerdings werden Hochdruck - Separationstanks entwickelt, die für den Betrieb auf dem Meeresboden einige 100 m unterhalb der Meeresoberfläche geeignet sind. Das geforderte und bereits separierte Öl kann dann mit viel geringerem Energieaufwand an die Meeresoberfläche gepumpt werden. Solche Separatortanks sind sehr hohen Drücken von 60 - 180 bar, nämlich von aussen dem Wasserdruck am Meeresgrund und von innen dem Druck des geförderten Erdöls, sowie hohen Temperaturen von 50 - 120 °C ausgesetzt. Das Füllstandsmesssystem muss unter diesen schwierigen Bedingungen jahrelang wartungsfrei und zuverlässig funktionieren. da ein Betriebsausfall und vorzeitiger Ersatz hohe Kosten verursachen würde.

Im Stand der Technik sind vielfältige Elektrodenanordnungen zur kapazitiven Messung der Elektrodenumgebung und damit zur Füllstandsbestimmung bekannt. Beispielsweise werden stabförmige Messsonden mit mehreren, entlang einer Sondenachse angeordneten Elektroden vorgeschlagen, die sich insbesondere den grossen Sprung der Dielektrizitätskonstanten an der Grenzfläche zwischen Ol und Wasser zunutze machen. Nachteilig an den bekannten Messsonden ist es, dass die Ortsauflösung durch die Periodizität der Elektrodenanordnung begrenzt ist und dazwischenliegende Füllstände nicht messbar sind. Auch sind Grenzschichten zwischen Medien gleicher Dielektrizitätskonstanten nicht nachweisbar. Für Medien mit unterschiedlicher Leitfähigkeit ist es bekannt, zur Ortung der Grenzschicht die ohmschen Entladeströme zwischen einzelnen

Elektroden zu messen. Hierfür ist eine Messfrequenz so niedrig zu wählen, dass in beiden Medien der ohmsche gegenüber dem kapazitiven Strom dominant ist. Bisher ist jedoch ausser Betracht geblieben, dass die Leitfähigkeit der Medien auf die Feldverteilung zwischen den Elektroden und damit auf die Grösse der Kapazitäten einen grossen Einfluss haben kann.

Die Verschmutzung der Messsonde durch die zu messenden Medien stellt ein grosses Problem für die Messgenauigkeit und Zuverlässigkeit derartiger Füllstandssensoren dar. Beispielsweise kann ein leitfähiger Wasserfilm die Detektion eines Ölmediums und ein nichtleitender Ölbelag die Detektion eines Wassermediums stören oder verunmöglichen.

In der DE 28 19 731 wird ein kapazitiver Sensor offenbart, der zu Grenzwertüberwachung eines adhäsiven, leitfähigen Mediums dient. Die Kapazitätsmessung erfolgt zwischen einer stabformigen Sonde und der Behälterwand. Durch leitfähige Ablagerungen auf der Sonde und der Wand können Fehlerströme verursacht werden, die von einer Schirmelektrode entlang der Sondenachse erfasst werden. Die Fehlerströme können auch durch möglichst hohe Messfrequenzen klein gehalten werden. Ein Nachteil dieser Anordnung besteht darin, dass die Füllstandshöhe nicht kontinuierlich messbar ist.

Die DE 38 12 687 A1 zeigt einen kapazitiven Sensor zur gleichzeitigen Bestimmung des Füllstands und des Wassergehalts einer zumindest schwach leitfähigen Flüssigkeit. Hierfür werden zwei koaxial angeordnete Elektroden in das Medium getaucht und bei mindestens zwei Frequenzen die komplexe Impedanz gemessen. Der kapazitive Blindwiderstand ist ein Mass für den Füllstand und der ohmsche Wirkwiderstand ein Mass für die Leitfähigkeit des Mediums.

Bei keinem der genannten Sensoren wird berücksichtigt, dass die Kapazitätsmessung in leitfähigen Medien durch ionischen Ladungstransport beeinflusst wird, woraus sich neue Möglichkeiten zur Optimierung der Elektrodengeometrie ergeben. Ferner kann der störende Einfluss isolierender Schmutzbeläge auf der Messsonde bisher nicht eliminiert werden.

## DARSTELLUNG DER ERFINDUNG

Aufgabe der vorliegenden Erfindung ist es, einen kapazitiven Füllstandssensor mit grosser Signalamplitude und/oder weitgehend kontinuierlichem Messbereich anzugeben. Diese Aufgabe wird erfindungsgemäss durch die Merkmale des Anspruchs 1 gelöst.

Kern der Erfindung ist es nämlich, eine stabförmige Sonde mit mehreren, entlang der Sondenachse angeordneten Elektroden auszurüsten, wobe ein Verhältnis von Elektrodenhöhe zu Elektrodenabstand grösser als eins gewählt ist.

Ein erstes Ausführungsbeispiel zeigt eine Messsonde, bei welcher durch Optimierung der Elektrodenhöhe die Kapazität zwischen benachbarten Elektroden für leitfähige Medien gross und für isolierende Medien klein gewählt ist.

Ein zweites Ausführungsbeispiel stellt eine Variante dar, bei welcher die Elektrodenhöhe möglichst gross gewählt ist, um einen weitgehend kontinuierlichen Messbereich zu realisieren.

In einem dritten Ausführungsbeispiel wird gezeigt, wie mit geeigneten Messfrequenzen leitfähige Schmutzfilme auf der Sonde detektierbar und ihr Einfluss auf das Kapazitätssignal eliminierbar ist.

In einem vierten Ausführungsbeispiel wird schhesslich gezeigt, wie mit radial versetzten Elektroden isolierende Schmutzfilme auf der Sonde detektierbar und ihr Einfluss auf das Kapazitätssignal eliminierbar ist.

Zusätzliche Ausführungsbeispiele ergeben sich aus den abhängigen Ansprüchen und aus der Kombination erfindungswesentlicher Merkmale.

Wichtige Vorteile des erfindungsgemässen kapazitiven Füllstandssensors betreffen die hohe Messgenauigkeit über einen grossen Füllstandsbereich, die Möglichkeit einer digitalen oder analogen Füllstandsanzeige und die verringerte Störanfälligkeit bei Verschmutzung.

Ein weiterer bedeutender Vorteil besteht darin, dass sämtliche Massnahmen, durch welche die Kapazitätssignale und der Messsbereich maximiert sowie die Störeinflüsse durch leitfähige und isolierende Schmutzfilme minimiert werden, miteinander gut kompatibel sind.

Des weiteren sind der einfache, robuste Aufbau ohne bewegliche Teile, die weitgehende Wartungsfreiheit und die hervorragende Eignung der Messsonde zur Detektion einer Grenzschicht zwischen Wasser und Öl vorteilhaft.

## KURZE BESCHREIBUNG DER ZEICHNUNGEN

Die Erfindung wird nachstehend anhand von Ausführungsbeispielen erläutert. Es zeigen:

Fig. 1     eine kapazitive Messsonde mit mehreren übereinander angeordneten Elektroden und rundem oder quadratischem Querschnitt;

Fig. 2     eine Detailansicht der Messsonde gemäss Fig. 1 mit Ersatzschaltbildern für die Impedanz zwischen einem Elektrodenpaar;

Fig. 3     ein Elektrodenpaar - Kapazitätsverhältnis $C_\sigma / C_\varepsilon$ für ein leitfähiges relativ zu einem isolierenden Medium als Funktion der Elektrodenhöhe h;

Fig. 4     eine Elektrodenpaar - Kapazität C als Funktion einer Füllstandshöhe z für zwei Dicken $d_e$ der Elektrodenabdeckung;

Fig. 5     eine Detailansicht der Messsonde mit einem leitfahigen Schmutzfilm und zugehörigem Ersatzschaltbild für die Impedanz zwischen einem Elektrodenpaar;

Fig. 6     eine Detailansicht einer Messsonde mit radial versetzten Elektroden zur Detektion eines isolierenden Schmutzfilms und zugehörigem Ersatzschaltbild für die Impedanz zwischen einem Elektrodenpaar.

In den Figuren sind gleiche Teile mit gleichen Bezugszeichen versehen.

## WEGE ZUR AUSFÜHRUNG DER ERFINDUNG

In einer früheren, nicht vorveröffentlichten deutschen Patentanmeldungen (Aktenzeichen 197 13 267.7) der Anmelderin wird ein kapazitiver Füllstandssensor vorgeschlagen, der insbesonders zum empfindlichen Nachweis von Änderungen der Dielektrizitätskonstanten des Umgebungsmediums geeignet ist. Die stabförmige, in sich geschlossene Messsonde trägt entlang der Achse mehrere ringförmige oder torusförmige, zum Teil in Längsrichtung segmentierte Elektroden. Die Streukapazität wird bevorzugt zwischen benachbarten Elektroden gemessen. Die Kapazitätssignale der Elektrodenpaare können einzeln für eine digitale Füllstandsanzeige oder gemittelt fur eine analoge Füllstandsanzeige verwendet werden. In beiden Fällen ist die Ortsauflösung durch die Periodizität der Elektrodenanordnung begrenzt. Es werden auch mehrere Massnahmen vorgeschlagen, um Messwertverfälschungen durch Verschmutzung der Sonde zu klein zu halten oder zu eliminieren. Beispielsweise kann die Sonde speziell für Messungen im Nah- und Fernbereich ausgelegt sein: die Streukapazitaten sind ein Mass für den Nahbereich der Messsonde, wenn die Elektroden grossflächig und/oder weit beabstandet sind, und ein Mass für den Fernbereich, wenn die Elektroden kleinflächig und/oder nah beabstandet sind. Nachteilig ist jedoch, dass die optimale Elektrodengeometrie nur im Hinblick auf die Reichweite der Streufelder in dielektrischen Medien und zudem nur qualitativ angegeben wird. Der Fernbereich ist schliesslich auch durch Kapazitätsmessungen zwischen der Sonde und einer zusätzlichen Gegenelektrode, z. B. der Behälterwand, gut erfassbar. Ferner kann der Nahbereich in leitfähigen Medien aufgrund des Skineffekts gemessen werden. Für Eindringtiefen im mm ~ Bereich sind aber höchste Frequenzen, im Fall von Wasser beispielsweise 10 GHz und darüber, erforderlich.

Die vorliegende Erfindung hat die Optimierung des kapazitiven Fülistandssensors zum Gegenstand, welcher besonders zur Ortsbestimmung einer Grenzschicht 12 zwischen Wasser 10 und Öl 11 in einem Separatortank geeignet ist.

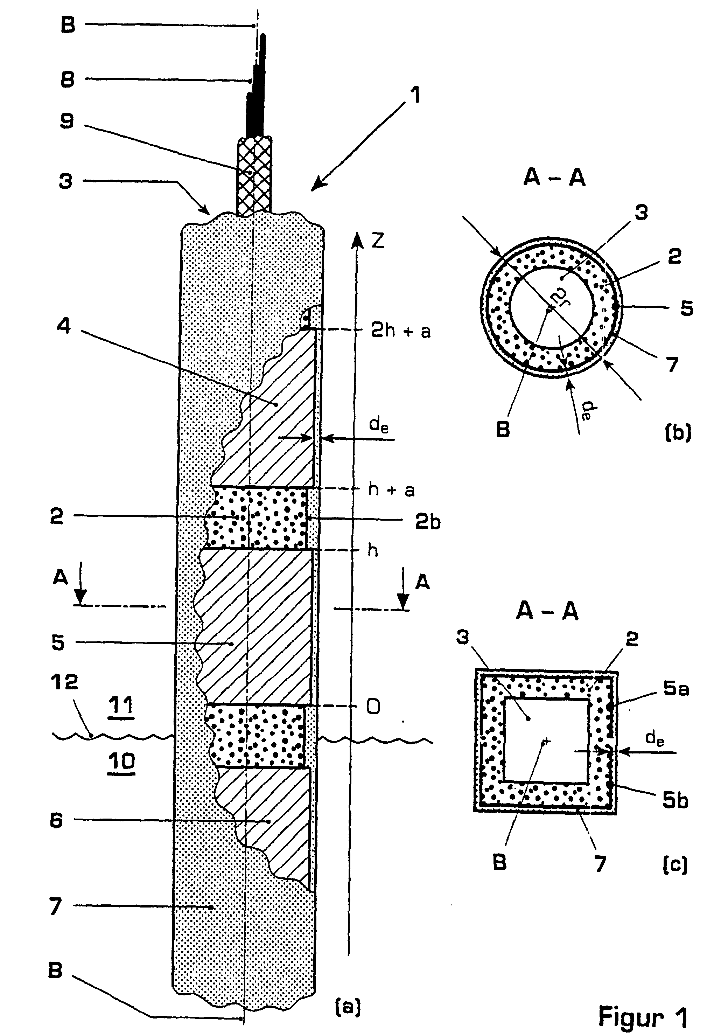

Fig. 1 zeigt ausschnittsweise (a) eine Seitenansicht eines erfindungsgemassen Füllstandssensors und (b), (c) Ausführungsbeispiele für einen rundem und rechteckigen Sensorquerschnitt. Der kapazitive Füllstandssensor umfasst eine stabförmige Sonde 1 mit mehreren, entlang einer Sondenachse B angeordneten Elektroden 4, 5, 6, 13, die über Messleitungen 8 mit einer nicht dargestellten Messelektronik verbunden sind. Die prinzipielle Funktionsweise beruht darauf, dass zwischen benachbarten Elektroden 13, 4; 4, 5; 5, 6 die Kapazitätsänderung gemessen wird, welche durch eine Verschiebung einer Grenzschicht 12 zwischen einem leitfähigen 10 und einem isolierenden Medium 11 verursacht wird.

Gemäss Fig. 1a besteht die Messsonde 1 im wesentlichen aus einem zylindrischen, elektrisch isolierenden Rohr 2, an dessen ausserer Mantelfläche 2b die Elektroden 4, 5, 6, 13 aufgebracht sind. Das Rohrinnere 3 ist gegenüber dem die Sonde 1 umgebenden Aussenraum abgeschlossen. Die Elektroden 4, 5, 6, 13 sind mit einer elektrisch isolierenden, dünnen Abdeckung 7 versehen, welche die Elektroden 4, 5, 6, 13 gegen mechanische und/oder chemische Umwelteinflüsse schützt. Die Sonde 1 kann einen beliebigen Querschnitt aufweisen. Bevorzugt ist das Rohr 2 kreiszylindrisch und sind die Elektroden 4, 5, 6, 13 ringförmig (Fig. 1b). Es können auch segmentförmige (Fig. 1c) Elektroden 5a, 5b zu einer einzigen Elektrode 5 zusammengeschlossen sein.

Zur Analyse und Optimierung der Elektrodengeometrie wird in der Erfindung von der wesentlichen Erkenntnis ausgegangen, dass der Sprung der Leitfähigkeit an der Grenzschicht 12 in erster Linie die Geometrie der beteiligten Kapazitäten und damit die Gesamtkapazität zwischen benachbarten Elektroden, d. h. die Elektrodenpaar - Kapazität C, ändert.

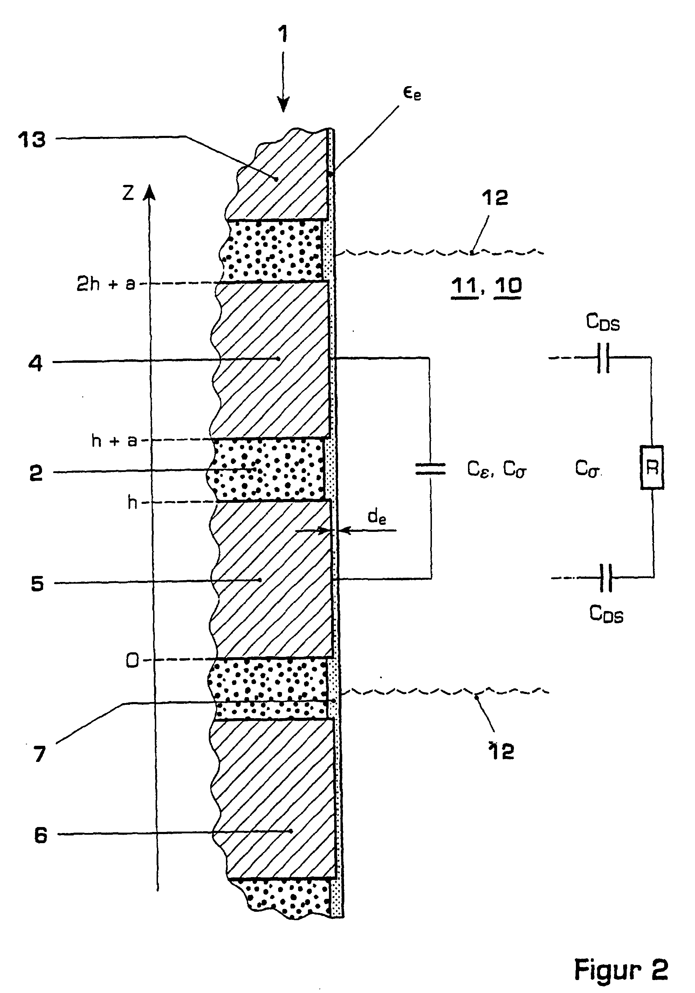

Fig. 2 stellt eine Detailansicht der Messsonde 1 mit einem erfindungsgemäss modellierten Ersatzschaltbild für die komplexe Gesamtkapazität zwischen den Elektroden 4 und 5 dar. Im isolierenden Medium 11 ist die Streukapazität $C_\varepsilon$ dominant, welche durch die Geometrie der Elektroden 4, 5 und die Dielektrizitätskonstante des Mediums 11 und des Stabmaterials gegeben ist und im konkreten Fall mit einem Finite - Elemente - Programm berechnet wird. In einem leitfähigen Medium 10 ist hingegen eine einfache analytische Darstellung möglich. In unmittelbarer Nachbarschaft zu den Elektroden 4, 5 werden Ladungen induziert und sehr grosse Doppelschichtkapazitäten $C_{DS}$ gebildet, welche über den Widerstand R des Mediums 10 miteinander verbunden sind und eine komplexe Gesamtkapazität

$$C_c = C_{DS}/[2 \cdot (1 + i \cdot \omega \cdot \tau)] \qquad \text{(G1)}$$

bilden. Hierbei bezeichnet i = imaginäre Einheit, $\omega = 2\pi \cdot f$, f = Frequenz der Kapazitätsmessung und $\tau$ = RC - Zeitkonstante der Doppelschichtkapazität bzw. dielektrische Relaxationszeit des RC - Kreises.

Die Doppelschichtkapazität lautet

$$C_{DS} = \varepsilon_e \cdot \varepsilon_0 \cdot A/d_e , \qquad \text{(G2)}$$

wobei $\varepsilon_e$ = Dielektrizitätskonstante und $d_e$ = Dicke der dielektrischen Elektrodenabdeckung 7, $\varepsilon_0$ = Influenzkonstante und A = Doppelschicht - Kondensatorfläche = Fläche der zugehörigen Elektrode (4, 5, 6, 13 inklusive Abdeckung 7). $C_{DS}$ ist somit durch die effektive Dicke $d_e / \varepsilon_e$ der Elektrodenabdeckung 7 und die Fläche der Elektrode 4, 5, 6, 13 gegeben, ist aber unabhängig von der Dielektrizitätskonstanten des leitfähigen Mediums 10.

Die dielektrische Relaxationszeit $\tau$ ist ein Mass für die Geschwindigkeit, mit welcher die Doppelschichtkapazität geladen bzw. gebildet wird. Man kann $\tau$ in der Form

$$\tau = R \cdot C_{DS}/2 = \tau_0 \cdot K = \varepsilon_e \cdot \varepsilon_0 \cdot \rho_M \cdot K \qquad (G3)$$

mit

$$K = (A/A_l) \cdot (h/d_e) \qquad (G3')$$

schreiben, wobei $\rho M$ = spezifischer Widerstand des Mediums 10, K = dimensionsloser Geometriefaktor, $A_l$ = effektive stromdurchflossene Fläche und h = Elektrodenhöhe. Typische Werte des Geometriefaktors sind $1 < K < 100$.

Ein Ziel der Erfindung ist es, diejenigen Elektrodenanordnungen anzugeben, für welche die Elektrodenpaar - Kapazität $C_\sigma$ für ein leitfähiges Medium 10 möglichst gross und $C_\varepsilon$ für ein isolierendes Medium 11 möglichst klein ist. Für die quantitative Analyse wird der Einfachheit halber angenommen, dass die Elektroden 4, 5, 6, 13 im abgerollten Zustand eine rechteckige Form der Höhe h und der Länge $2 \cdot \pi \cdot (r + d_e)$ aufweisen und daher wegen $d_e << r$ die Kondensatorfläche $A = 2 \cdot \pi \cdot r \cdot h$ beträgt, wobei r = Radius der Sonde 1. Gemäss Fig. 2 wird der Elektrodenabstand a zwischen der Oberkante einer unteren Elektrode 4, 5, 6 und der Unterkante einer oberen Elektrode 13, 4, 5 gemessen.

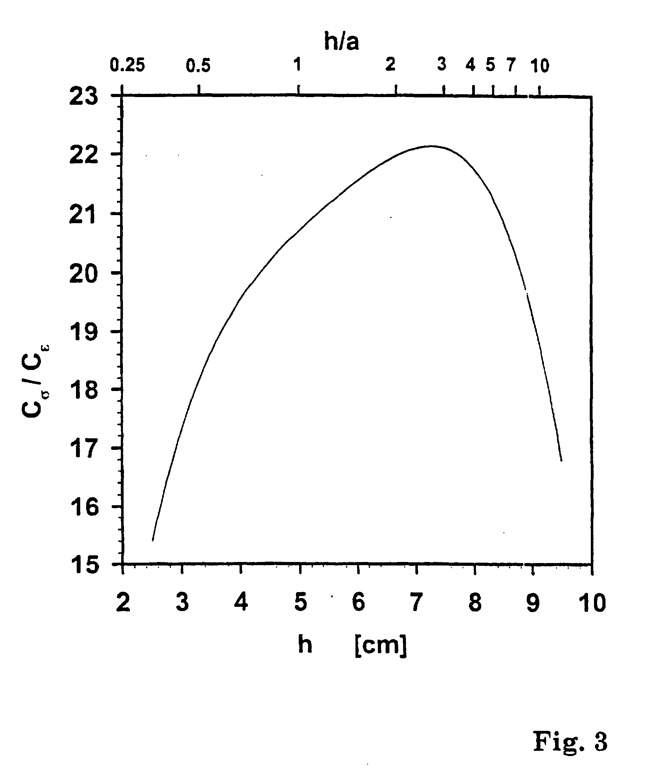

Fig. 3 zeigt das Ergebnis einer numerischen Simulation des Kapazitätsverhältnisses $C_\sigma / C_\varepsilon$ als Funktion der Elektrodenhöhe h und des Verhältnisses von Elektrodenhöhe zu Elektrodenabstand h / a. Für die Berechnung wurden die folgenden Annahmen getroffen: Sondenradius r = 5 cm, konstante Periodizität der Elektrodenanordnung a + h = 10 cm, Salzwasser als Medium 10 mit $\varepsilon_1 = 64$ und $\rho_1 = 0,25$ $\Omega$m zur Bestimmung von $C_\sigma$, Öl als Medium 11 mit $\varepsilon_2 = 2,2$ und $\rho_2 = 10^{11}$ $\Omega$m zur Bestimmung von $C_\varepsilon$ und $\varepsilon_e \approx \varepsilon_2$. Entgegen der bisherigen Auffassung ist das Kapazitätsverhältnis $C_\sigma / C_\varepsilon$ für kleine Elektrodenhöhen h bzw. grosse Elektrodenabstände a klein, obwohl doch das elektrische Streufeld für grosse a weiter in die Medien 10, 11 hineinragen und besonders sensibel auf

Veränderungen der Dielektrizitätskonstanten reagieren sollte. Statt dessen steigt $C_\sigma / C_\varepsilon$ mit zunehmender Elektrodenhöhe h an, erreicht bei ca. h = 7,5 cm oder h / a = 3 ein Maximum und fällt danach für $h \to 10$ cm steil ab. Der Anstieg ist durch die Zunahme der Elektroden- bzw. Kondensatorfläche A der Doppelschichtkapazität $C_{DS}$ in $C_\sigma$ dominiert, der Abfall hingegen durch die Zunahme von $C_\varepsilon$ aufgrund des abnehmenden Elektrodenabstands $a \to 0$. In diesem Ausführungsbeispiel beträgt $C_\sigma / C_\varepsilon = 20,7$ für eine symmetrische Anordnung mit

Elektrodenhöhe gleich Elektrodenabstand oder h / a = 1. Insbesondere ist $C_\sigma / C_\varepsilon > 20,7$ für $1 < h / a < 6$ und $C_\sigma / C_\varepsilon = 22,2$ ($C_\sigma = 378$ pF, $C_\varepsilon = 17$ pF) maximal für $h / a \approx 3$. Demzufolge ist h / a für einen hinreichend grossen Signalhub $2 \cdot C_\sigma / C_\varepsilon$ mit Vorteil zwischen 0,5 und 12, vorzugsweise zwischen 1 und 6, besonders bevorzugt zwischen 1,5 und 4,5, insbesondere gleich 3, gewählt.

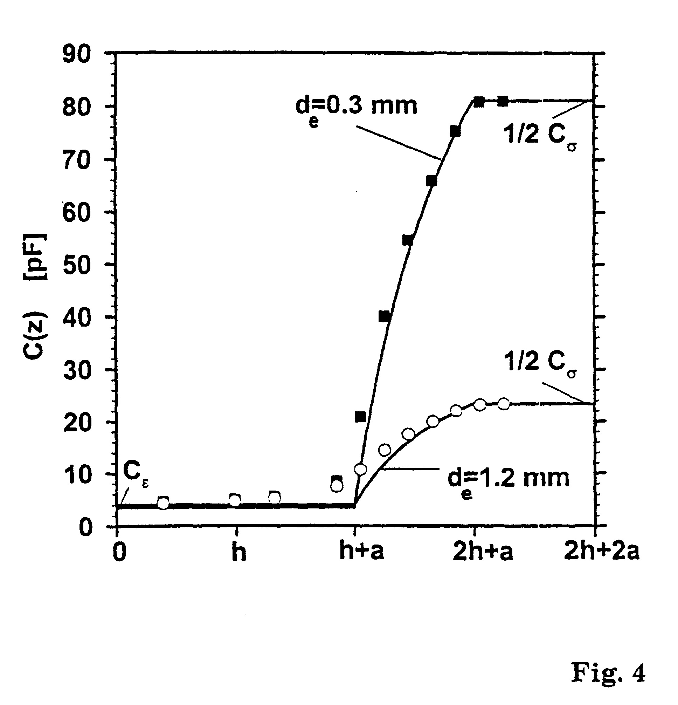

Die erfindungsgemässe Optimierung der Elektrodengeometrie umfasst ausser der Wahl einer relativen Elektrodenhöhe h / a auch die einer absoluten Elektrodenhöhe h sowie einer Dicke $d_e$ und Dielektrizitätskonstanten $\varepsilon_e$ der Elektrodenabdeckung 7. In Fig. 4 zeigen die durchgezogenen Linien analytische Berechnungen und die Punkte numerische Berechnungen der Elektrodenpaar - Kapazität C als Funktion der Füllstandshöhe z für zwei Dicken $d_e = 0,3$ mm und $d_e = 1,2$ mm der Elektrodenabdeckung 7. Die analytische Funktion C(z) ist erfindungsgemäss durch die Gleichung

$$
\begin{array}{lll}
C(z) = C_\varepsilon & \text{für } 0 \leq z \leq h + a & \\
\quad\;\; = C_\varepsilon + C_\sigma \cdot z / (z + h) & \text{für } h + a \leq z \leq 2 \cdot h + a & (G4) \\
\quad\;\; = C_\sigma / 2 & \text{für } 2 \cdot h + a \leq z \leq 2 \cdot (h + a) &
\end{array}
$$

approximierbar, wobei der Einfachheit halber $C_\varepsilon \ll C_\sigma$ angenommem wurde. Nach Fig. 4 und Gleichung G4 ist die Messung der Elektrodenpaar - Kapazität C(z) sowohl für eine digitale als auch analoge Anzeige des Ortes z der Grenzschicht 12 verwendbar.

Zunächst wird die digitale Anzeige anhand des Elektrodenpaares 4, 5 in Fig. 2 diskutiert. Die Kapazität C(z) ist für $0 \leq z \leq h + a$ weitgehend konstant. Sie springt von $C_\varepsilon$ auf den Wert $C_\sigma / 2$, wenn die Grenzschicht 12 von z = h + a bis z = 2 · h + a steigt, und behält zwischen z = 2 · h + a und z = 2 · (h + a) den im wesentlichen konstanten Wert

$C_\sigma / 2$ bei. Anschaulich bedeutet dies, dass für $z < 0$ eine rein geometrische Kapazität $C_\varepsilon$ in einem Dielektrikum 11 vorliegt und für $z > 2 \cdot h + a$ zwei Doppelschichtkapazitäten $C_{DS}$ an den vollständig in das leitfähige Medium 10 eingetauchten Elektroden 5 und 4. Die numerische Lösung zeigt, dass $C(z)$ zwischen 0 und $h + a$ geringfügig ansteigt und im Bereich $z = h + a$ die Steigung von $C(z)$ kontinuierlich zunimmt. Beide Lösungen zeigen, dass der bevorzugte Messbereich im Gebiet des grossen Kapazitätsanstiegs zwischen $h + a$ und $2 \cdot h + a$ liegt. Daher wird man für einen optimalen Sensorbetrieb bevorzugt diejenige Elektrodenpaar - Kapazität $C(z)$ auswerten, für welche die untere Elektrode vollständig und die obere Elektrode teilweise in das leitfähige Medium 10 eingetaucht ist.

Ein Vorteil der digitalen Anzeige ist es, dass der Signalhub $2 \cdot C_\sigma / C_\varepsilon$ je nach gefordertem Signal - Rausch - Verhältnis und Art der Medien 10, 11 durch eine geeignete Wahl der relativen Elektrodenhöhe $h / a$ gemäss Fig. 3 angepasst und insbesondere optimiert werden kann. Ein weiterer Vorteil besteht darin, dass eine für Separatortanks ausreichende und zuverlässige Höhenauflösung $h + a \approx 5$ cm bis 10 cm erzielbar ist, indem die Periodenlänge $h + a$ der Elektrodenanordnung 4, 5, 6, 13 entsprechend gewählt ist.

Eine sehr feine Höhenauflösung kann darüberhinaus mit einer analogen Anzeige realisiert werden. Für diesen Zweck ist mit Gleichung G4 aus dem analogen Messsignal $C(z)$ im Bereich $h + a \leq z \leq 2 \cdot h + a$ (bzw. $2 \cdot h + 2 \cdot a \leq z \leq 3 \cdot h + 2 \cdot a$, usw.) eine Füllstandshöhe $z$ der Grenzschicht 12 bestimmbar. Der für ein gegebenes Elektrodenpaar 5, 4 nützliche Messbereich $h + a \leq z \leq 2 \cdot h + a$ ist dadurch charakterisiert, dass die Grenzschicht 12 gerade die Elektrode 4 überstreicht und dort die dominante Doppelschichtkapazität $C_{DS}$ variiert. Zwischen den Elektroden 5, 4 existiert hingegen ein Totbereich $h \leq z \leq h + a$. Für einen analog betriebenen Füllstandssensor sollen daher die absolute Elektrodenhöhe $h$ möglichst gross und die relative Elektrodenhöhe $h / a$ in einem Bereich mit hinreichend grossem Signalhub $2 \cdot C_\sigma / C_\varepsilon$ gemäss Fig. 3 gewählt sein. Dies bedeutet, dass $h / a$ erfindungsgemäss grösser als 1 und vorzugsweise kleiner als 12 gewählt ist. Ein Vorteil der Erfindung besteht somit darin, dass die Messsonde 1, insbesondere die relative Elektrodenhöhe $h / a$, gleichzeitig für eine digitale und analoge Anzeige optimierbar ist.

Ein durchgehender analoger Messbereich kann auch durch zwei unabhängige, zueinander versetzt angordnete Messsonden 1 mit überlappenden oder zumindest komplementären Messbereichen realisiert sein. Im einfachsten Fall sind die Sonden 1 identisch und weisen wiederum ein Verhältnis von Elektrodenhöhe zu Elektrodenabstand $h / a$ grösser als 1 auf.

Aus Fig. 4 und den Gleichungen G1 und G2 ist ferner ersichtlich, dass die Elektrodenabdeckung 7 möglichst dünn sein soll, um eine grosse Doppelschichtkapazität $C_{DS}$ und einen grossen Signalhub $2 \cdot C_\sigma / C_\varepsilon$ zu erhalten. Mit Vorteil weist die Abdeckung 7 eine Dicke de kleiner als 2,5 mm, bevorzugt kleiner als 1,5 mm und insbesondere kleiner als 1 mm auf. Die Abdeckung 7 wirkt als dielektrische Abschirmung für das E - Feld im Aussenraum und behindert dadurch die Ausbildung der Doppelschichtkapazität $C_{DS}$. Mit Vorteil weist die Abdeckung 7 eine Dielektrizitätskonstante $\varepsilon_e$ kleiner als 10 und insbesondere kleiner als 5 auf.

Die obigen Betrachtungen beziehen sich auf eine Grenzschicht 12 zwischen einem Ionenleiter bzw. Elektrolyten 10 und einem Isolator 11. Bei den Berechnungen wurde die Frequenz $f$ der Kapazitätsmessung gleich null gesetzt. Die Resultate behalten jedoch ihre Gültigkeit, wenn die Kapazitätsmessung anstatt mit Gleichspannung mit Wechselspannung der Frequenz

$$f < \tau_1^{-1} \approx (K \cdot \varepsilon_e \cdot \varepsilon_0 \cdot \rho 1)^{-1} = f_1 \qquad \text{(G5)}$$

durchgeführt wird. Die dielektrische Grenzfrequenz $f_1$ beträgt für Salzwasser typischerweise 1 GHz.

Die erfindungsgemässe Elektrodenoptimierung behält ebenfalls ihre Gültigkeit, wenn eine Grenzschicht 12 zwischen zwei leitfähigen Medien 10, 11 mit unterschiedlichen spezifischen Widerständen $\rho_1 \ll \rho_2$ geortet werden soll. Die durch die Grenzschicht 12 separierten Medien 10, 11 weisen dann gemäss Gleichung G5 unterschiedliche dielektrische Grenzfrequenzen $f_1 = (K \cdot \varepsilon_e \cdot \varepsilon_0 \cdot \rho_1)^{-1}$ und $f_2 = (K \cdot \varepsilon_e \cdot \varepsilon_0 \cdot \rho_2)^{-1}$ auf und die Frequenz der Kapazitätsmessung bzw. Messfrequenz $f$ kann zwischen den Grenzfrequenzen $f_2$ und $f_1$, d. h. im Frequenzbereich

$$f_2 \ll f \ll f_1 \qquad \text{(G6)}$$

gewählt sein. Das leitfähigere Medium 10 ist dann in der Lage, eine Doppelschichtkapazität $C_{DS}$ zu bilden, wohingegen im weniger leitfähigen Medium 11 nur die geometrische Kapazität $C_\varepsilon$ wirksam ist. Für Öl 11 gilt $f_2 \ll 1$ Hz .

Die Gestalt der Elektroden 4, 5, 6, 13 ist nicht auf die erwähnte Rechteckform beschränkt. Prinzipiell können die Elektroden 4, 5, 6, 13 im abgerollten Zustand auch eine Trapezform, Dreiecksform o. ä. aufweisen. Die Regeln für die Elektrodenoptimierung bleiben qualitativ weitgehend unverändert, wenn die Elektrodenhöhe $h$ und der Elektrodenabstand $a$ durch mittlere oder Effektivwerte $h_{eff}$ und $a_{eff}$ ersetzt werden.

Ein weiterer Gegenstand der Erfindung ist es, auch bei Anwesenheit eines leitfähigen oder elektrisch isolierenden Schmutzfilms 14 auf der Staboberfläche 15 eine zuverlässige Kapazitätsmessung bzw. Füllstandsbestimmung zu gewährleisten.

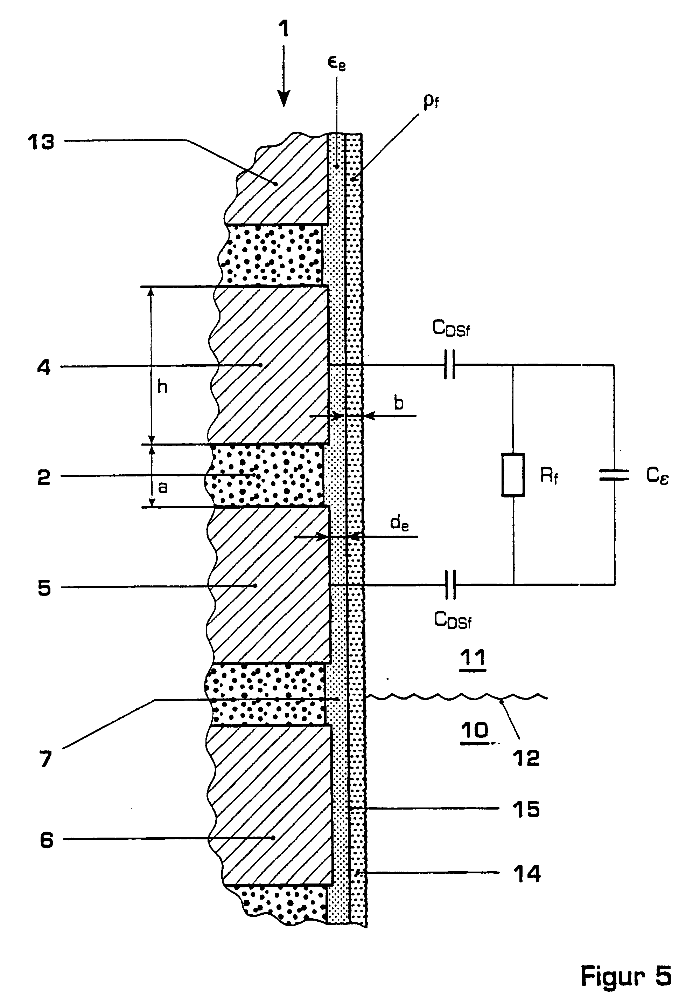

Fig. 5 zeigt ausschnittweise eine Messsonde 1, die von einem mehr oder weniger leitfähigen Schmutzfilm 14 der Dicke b und des spezifischen Widerstands $\rho f$ bedeckt und in ein isolierendes Medium 11 eingetaucht ist. Beispielsweise kann der Schmutzfilm 14 aus Wasser oder einer Wasser - Öl - Emulsion bestehen. Einerseits trägt der Film 14 mit zwei Doppelschichtkapazitäten $C_{DSf}$ gemäss Gleichung G2

$$C_{DSf} = \varepsilon_e \bullet \varepsilon_0 \bullet 2 \bullet \pi \bullet r \bullet h/d_e \qquad (G7)$$

zur geometrischen Kapazität $C_\varepsilon$ im Medium 11 bei, wobei der Einfachheit halber eine ringförmige Elektrode angenommen wurde. Andererseits wirkt der Film 14 als elektrischer Leiter parallel zu $C_\varepsilon$ mit dem Widerstand

$$R_f = h_f \bullet \rho_f/(2 \bullet \pi \bullet r \bullet b), \qquad (G8)$$

wobei $h_f$ eine effektive Länge des Leitfähigkeitpfades zwischen zwei Elektroden 4, 5 bezeichnet. Näherungsweise kann $h_f$ gleich a + h / 2 oder gleich h gesetzt werden. Die charakteristische RC - Zeitkonstante des Films 14

$$\tau_f = R_f \bullet C_{DSf}/2 = \tau_{f0} \bullet G \qquad (G9)$$

setzt sich aus einer materialspezifischen Zeitkonstante

$$\tau_{f0} = \varepsilon_e \bullet \varepsilon_0 \bigcirc \rho_f \qquad (G10)$$

und einem schichtbedingten dimensionslosen Geometriefaktor

$$G = h \bullet h_f/(2 \bullet d_e \bullet b) \approx h^2/(2 \bullet d_e \bullet b) \qquad (G11)$$

zusammen. Die Relaxationszeit $\tau_f$ definiert eine charakteristische Frequenz des Schmutzfilms 14

$$f(b) = \tau_f^{-1} = 2 \bullet (\varepsilon_e \bullet \varepsilon_0 \bullet \rho_f)^{-1} \bullet (d_e/h^2) \bullet b \ , \qquad (G12)$$

die insbesondere von der Dicke b des leitfähigen Schmutzfilms 14 abhängt. Die gesamte Elektrodenpaar - Kapazität nimmt unterhalb bzw. oberhalb der charakteristischen Frequenz f(b) asymptotisch die Werte

$$C(f) = C_{DSf} / 2 \qquad \text{für} \ \ f < f(b)$$

$$= C_\varepsilon \qquad \text{für} \ \ f > f(b) \qquad (G13)$$

an. Bei tiefen Frequenzen f < f(b) kann der Schmutzfilm 14 ein leitfähiges Medium 10 simulieren, obwohl hinter dem Film 14 ein isolierendes Medium 11 verborgen ist. Bei hohen Frequenzen f > f(b) hingegen erscheint der Schmutzfilm 14 dielektrisch transparent. Folglich ist die Messfrequenz f mit Vorteil grösser als f(b) gewählt. Hierzu ein quantitatives Beispiel: $\rho_f \approx 0{,}25 \ \Omega m$ (Salzwasser - Schmutzfilm 14), $\varepsilon_e \approx 3$, $\tau_{f0} \approx 7$ ps; $h \approx h_f \approx 15$ mm, $d_e = 0{,}5$ mm, b = 1 mm, Geometriefaktor $G \approx 200 \rightarrow f(b) = 100$ MHz. Man beachte, dass die Leitfähigkeit des Wassers stark mit dem temperatur- und druckabhängigen Salzgehalt variiert, was durch eine geeignete Frequenzwahl berücksichtigt werden kann. Besteht der Schmutzfilm 14 aus einer Emulsion von Salzwasser der Konzentration c und Öl der Konzentration 1 - c, kann $\rho_f \approx \rho_{Salzwasser}^c \cdot \rho_{Ol}^{1-c}$ approximiert werden und die charakteristische Frequenz f(b) sinkt entsprechend. Für ein beliebiges Medium 10 der Konzentration c und Medium 11 der Konzentration 1 - c darf $\rho_f \approx \rho 1^c \bullet \rho 2^{1-c}$ gesetzt werden.

Im folgenden werden zwei Ausführungsbeispiele angegeben, wie bei veränderlicher Filmdicke b die Füllstandsmessung auf einfache Weise durchführbar ist. Erstens kann eine maximal zulässige Filmdicke $b_c$ und eine zugehörige kritische Frequenz $f_c$ vorgegeben sowie eine Messfrequenz oberhalb von $f_c$

$$f > f_c = f(b_c) = 2 \cdot (\varepsilon_e \cdot \varepsilon_0 \cdot \rho_f)^{-1} \cdot (d_e/h^2) \cdot b_c \qquad \text{(G14)}$$

gewählt sein. Die Einhaltung einer Filmdicke $b < b_c$ kann dann beispielsweise dadurch sichergestellt sein, dass bei ungefähr bekannter Verschmutzungsrate entsprechende Reinigungsintervalle festgelegt werden. Zweitens können eine maximal zulässige Filmdicke $b_c$ und eine zugehörige kritische Frequenz $f_c$ vorgegeben sowie zwei Messfrequenzen unterhalb bzw. oberhalb von $f_c$

$$f_a < f_c = f(b_c) \text{ und } f_b > f_c = f(b_c) \qquad \text{(G15)}$$

gewählt sein. Bei Annäherung der aktuellen Filmdicke $b$ an den kritischen Wert $b_c$ wird dann zunächst der bei niedrigeren Frequenz gemessene Kapazitätswert $C(f_a)$ absinken und der bei höherer Frequenz gemessene Kapazitätswert $C(f_b)$ konstant bleiben. Mit Hilfe einer solchen Signalsignatur können z. B. die Menge eines Inhibitorzusatzes zur chemischen Auflösung des Schmutzfilms 14 geregelt, eine Reinigung des Messstabs 1 mittels eines axial beweglichen Ringes veranlasst oder andere geeignete Massnahmen ergriffen werden.

Ein grosser Vorteil dieser messtechnischen Eliminierung eines leitfähigen Schmutzfilms 14 besteht darin, dass die Wahl der Messfrequenz(en) nach Gleichung G14 oder G15 mit der Optimierung der Elektrodenhöhe $h$ und der Wahl der Messfrequenz nach Gleichung G6 gut kompatibel ist. Im allgemeinen ist nämlich für die Medien 10, 11 und einen Schmutzfilm 14 eine kritische Frequenz $f_c$ so gegeben oder wählbar, dass $f_2 < f_c < f_1$ erfüllt ist. Insbesondere gilt praktisch immer

$$f_c/f_1 = (\rho_l/\rho_f) \cdot G^{-1} < 1 , \qquad \text{(G16)}$$

da typischerweise $\rho_1 \leq \rho_f$ und $G^{-1} = (2 \cdot d_e \cdot b) / h^2 \approx 10^{-2}...10^{-3}$. Dann ist eine Messfrequenz im Frequenzbereich $f_c < f < f_1$ wählbar, für welche der Schmutzfilm 14, aber nicht das leitfähige Medium 10 transparent ist. Zudem wird in völliger Übereinstimmung mit der erfindungsgemässen Elektrodenoptimierung mit Vorteil die Elektrodenhöhe $h$ gross und die Dicke $d_e$ der Abdeckung 7 klein gewählt, um den Geometriefaktor $G$ möglichst gross und die kritische Frequenz $f_c$ des Schmutzfilms 14 möglichst klein zu machen.

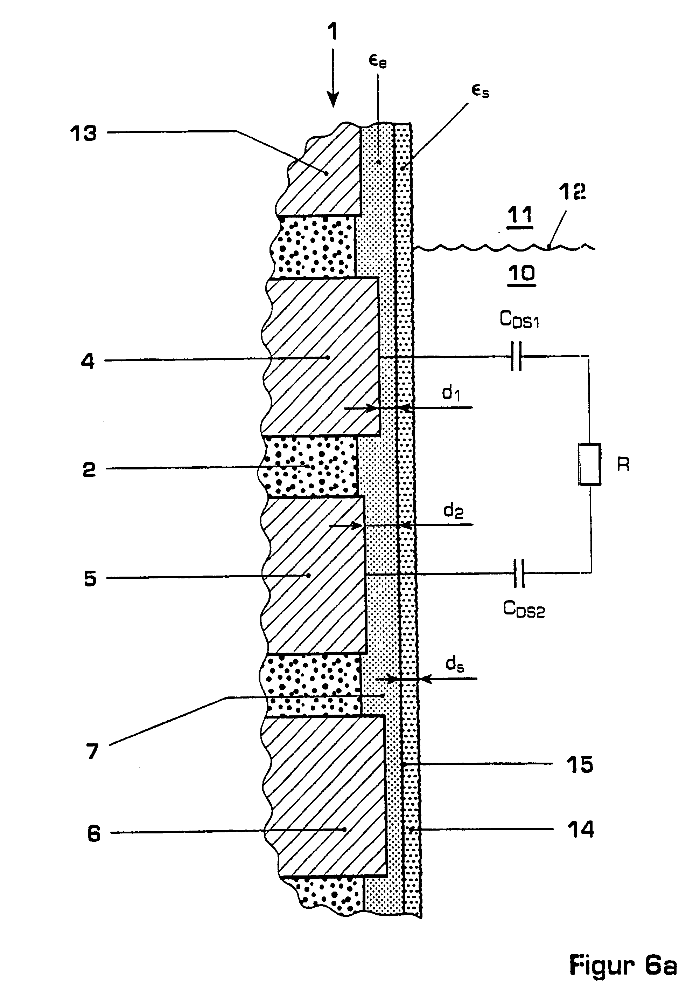

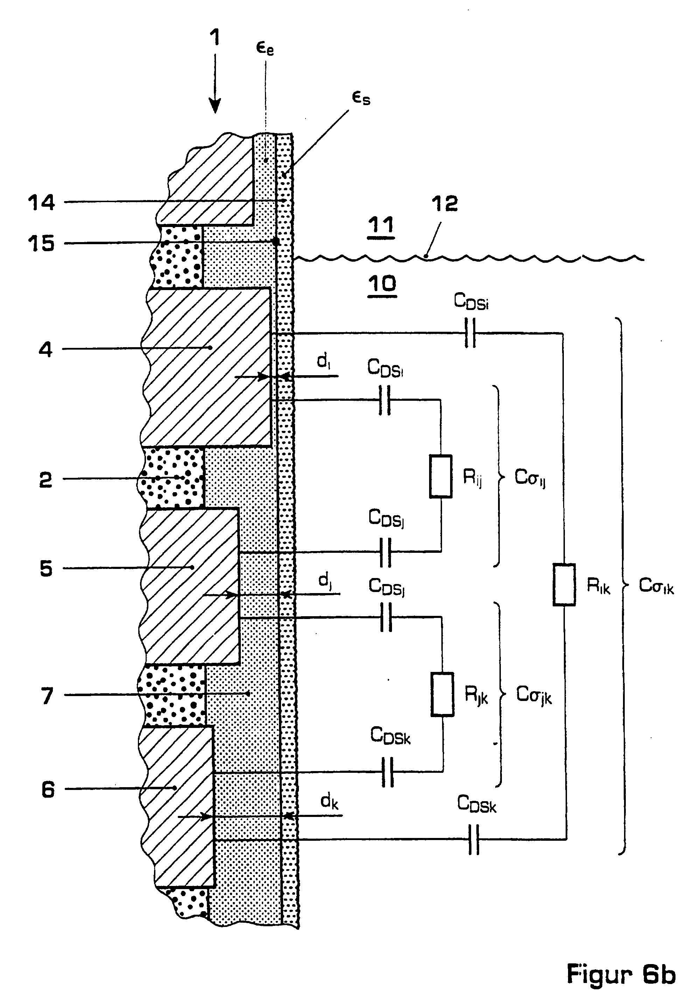

Fig. 6 zeigt Ausführungsbeispiele einer Elektrodenanordnung 4, 5, 6, 13, die besonders zur kapazitiven Füllstandsmessung bei Anwesenheit eines isolierenden Schmutzfilms 14 geeignet ist. Die erfindungsgemässe Idee besteht darin, dass die Sonde 1 Elektroden 4, 5, 6, 13 mit Abdeckungen 7 unterschiedlicher Dicken $d_1$ aufweist. Im folgenden seien die Elektroden 4, 5, 6 als die i - te, j te und k - te Elektrode mit den zugehörigen Abdeckungsdicken $d_i$, $d_j$ und $d_k$ und Kondensatorflächen $A_1$, $A_j$ und $A_k$ bezeichnet, wobei i, j, k = 1, 2, ..., n Indizes zur Durchnumerierung der Eiektroden und n die Gesamtzahl der Elektroden 4, 5, 6, 13 ist. In einem leitfähigen Medium 10 treten im Fall $d_i \neq d_j$ unterschiedliche Doppelschichtkapazitäten $C_{DSi} \neq C_{DSj}$ vor der i - ten und j - ten Elektrode 4, 5 auf, die unterschiedlich stark mit der effektiven Dicke $d_s / \varepsilon_s$ des isolierenden Schmutzfilms 14 variieren, wobei $d_s$ = geometrische Dicke und $\varepsilon_s$ = Dielektrizitätskonstante des Films 14. In Analogie zur Gleichung G2 gilt nämlich für die durch den Film 14 verfälschten Werte der Doppelschichtkapazitäten

$$C_{DSi} = \varepsilon_0 \cdot A_i / (d_i / \varepsilon_e + d_s / \varepsilon_s) , \qquad \text{(G17)}$$

$$C_{DSj} = \varepsilon_0 \cdot A_j / (d_j / \varepsilon_e + d_s / \varepsilon_s) . \qquad \text{(G18)}$$

Daraus ist erfindungsgemäss die effektive Dicke des Films 14

$$d_s/\varepsilon_s = (d_i/\varepsilon_c) \cdot [(C_{DSj} \cdot d_j \cdot A_i)/(C_{DSi} \cdot d_i \cdot A_j) - 1]/[1 - C_{DSj} \cdot A_i/C_{DSi} \cdot A_j] \qquad \text{(G19)}$$

bestimmbar, was sich für gleiche Kondensatorflächen $A_i = A_j = A$ vereinfacht zu

$$d_s/\varepsilon_s = (d_i/\varepsilon_e) \cdot [(C_{DSj} \cdot d_j)/(C_{DSi} \cdot d_i)-1]/[1-C_{DSj}/C_{DSi}]. \qquad (G20)$$

Der Quotient der Doppelschichtkapazitäten $C_{DSj}/C_{DSi}$ in Gleichung G19 oder G20 ist durch Kapazitätsmessungen zwischen mehreren Elektroden 4, 5, 6, 13 bestimmbar. Mit Vorteil weisen benachbarte Elektroden 13, 4; 4, 5; 5, 6 unterschiedliche Dicken $d_i \neq d_j$ $(j = i + 1)$ und übernächst benachbarte Elektroden 13, 5 bzw. 4, 6 gleiche Dicken $d_i = d_k$ $(k = i + 2)$ der Abdeckung 7 auf. Dann sind die in Anwesenheit des Films 14 gemessenen Kapazitätswerte zwischen übernächsten Elektroden 4, 6 bzw. 13, 5 für kleine Frequenzen gleich $C_{\sigma i} = C_{DSi} / 2$ bzw. $C_{\sigma j} = C_{DSj} / 2$ und es gilt

$$C_{DSj} / C_{DSi} = C_{\sigma j} / C_{\sigma i} . \qquad (G21)$$

Fig. 6b zeigt einen allgemeinen Fall unterschiedlicher Abdeckungsdicken $d_i \neq d_j \neq d_k$ über den Elektroden 4, 5, 6. Dann gilt

$$C_{DSj} / C_{DSi} = (C_{\sigma ij}^{-1} + C_{\sigma ik}^{-1} - C_{\sigma jk}^{-1}) / (C_{\sigma ij}^{-1} + C_{\sigma jk}^{-1} - C_{\sigma ik}^{-1}) , \qquad (G22)$$

wobei die $C_{\sigma ij}^{-1} = C_{DSi}^{-1} + C_{DSj}^{-1}$ usw. die Gesamtkapazitäten bezeichnen, die zwischen der i - ten und j - ten usw. Elektrode gegebenenfalls frequenzselektiv messbar sind.

Prinzipiell können also die Dicken $d_1$ der Abdeckung 7 beliebig gewählt sein, sofern benachbarte, d. h. zu einer Elektrodenpaar - Kapazität C gehörige, Elektroden 13, 4; 4, 5; 5, 6 unterschiedliche Dicken $d_i \neq d_{i+1}$ aufweisen. Unterschiedliche Dicken $d_i \neq d_{i+1}$ können auch für Elektroden 4, 5, 6, 13 mit gleichem Querschnitt, insbesondere gleichem Radius, realisiert sein, indem die Oberfläche 15 der Sonde 1 stufenförmige, insbesondere ringförmige, Erhöhungen mit unterschiedlichen Stufenhöhen über benachbarten Elektroden 13, 4; 4, 5; 5, 6 aufweist. Dann sind in den Gleichungen G17 - G19 die entsprechenden Werte der zugehörigen Kondensatorflächen $A_1$ und $A_j$ einzusetzen. Wie aus Fig. 6a ersichtlich sind vorzugsweise die Oberfläche 15 der Sonde 1 kreiszylindrisch, die Elektroden 4, 5, 6, 13 ringförmig, ihre Kondensatorflächen $A_1 = A_j$ gleich, benachbarte Elektroden 13, 4; 4, 5; 5, 6 weisen unterschiedliche Dicken $d_i \neq d_{i+1}$ und übernächst benachbarte Elektroden 13, 5; 4, 6 gleiche Dicken $d_i = d_{i-2}$ der Abdeckung 7 auf.

Die mit Hilfe der Gleichungen G20 oder G21 bestimmte effektive Dicke $d_s / \varepsilon_s$ eines dielektrischen Schmutzfilms 14 kann auf verschiedene Weise zur Kontrolle und/oder Korrektur der Füllstandsmessung benutzt werden. Beispielsweise sind unverfälschte Werte der Doppelschichtkapazitäten und der Gesamtkapazität $C_\sigma$ durch rechnerische Eliminierung von $d_s / \varepsilon_s$ in den Gleichungen G17 - G20 bestimmbar. Darüberhinaus können wiederum geeignete Massnahmen ergriffen werden, sobald $d_s / \varepsilon_s$ einen vorgebbaren kritischen Wert überschreitet. Diese umfassen insbesondere eine bedarfsmässige oder periodische Reinigung der Messsonde 1, eine Regelung einer Inhibitormenge o. ä..

Die Variation der Abdeckungsdicke $d_1$ zur Detektion eines isolierenden Schmutzfilms 14 weist mehrere Vorzüge auf. Eine radiale Versetzung der Elektroden 4, 5, 6, 13 ist problemlos mit einer Optimierung der Elektrodenhöhe h, aber auch mit einer Wahl der Messfrequenz nach den Gleichungen G6 oder G14, G15 vereinbar. Insbesondere kann die Grossflächigkeit und vertikale Orientierung der Elektroden 4, 5, 6, 13 beibehalten werden, wodurch das Kapazitätsverhältnis $C_\sigma / C_\varepsilon$ besonders gross wird. Zudem bestehen, wie eingangs erwähnt, bezüglich des Querschnitts der Sonde 1 prinzipiell keine Einschränkungen. Gegebenenfalls sind in den Gleichungen G7 · G21 geometrische Grössen, wie z. B. die Elektrodenhöhe h, die Kondensatorflächen $A_i$, die Dicken $d_i$ der Abdeckung 7 oder die Filmdicken b, $b_c$ und $d_s$, durch mittlere oder Effektivwerte zu ersetzen.

Das Rohr 2 besteht aus einem Dielektrikum wie Kunststoff, Plexiglas, PVC, Glas, Keramik oder dgl.. Das Rohrinnere 3 mit den Messleitungen 8 und Ummantelungen 9 ist vorteilhafterweise mit einem Epoxydharz ausgegossen. Dies gewährleistet stabile Grundkapazitäten und macht die Sonde 1 hochdruckbeständig. Die Elektrodenabdeckung 7 besteht beispielsweise aus einem giessfähigen Überzug aus Epoxydharz oder aus Glas, einer Keramik, Glimmer o. ä. und ist insbesondere faserverstärkt. Bevorzugt besteht die Elektrodenabdeckung 7 aus einer ca. 0,5 mm ... 1 mm dünnen, stabilen Glasfaserummantelung, die mit Epoxydharz überstrichen ist. Für eine gute mechanische Temperaturbeständigkeit der Sonde 1 werden bevorzugt Materialien mit ähnlichen thermischen Ausdehnungskoeffizienten verwendet.

Insgesamt offenbart die Erfindung eine kapazitive Messsonde 1, die sich durch grossflächige, relativ dicht beabstandete, vorzugsweise radial versetzte Elektroden 4, 5, 6, 13 auszeichnet und mit Frequenzen zu betreiben ist, die an die Leitfähigkeit der Medien 10, 11 und eines Schmutzfilms 14 angepasst sind. Die Sonde 1 ist daher sehr gut zur genauen Füllstandsmessung in Gegenwart beliebiger Schmutzfilme 14 geeignet.

BEZUGSZEICHENLISTE

| | |
|---|---|
| 1 | kapazitive Messsonde, Messstab |
| 2 | Rohr |
| 2b | Mantelfläche |
| 3 | Rohrinneres |
| 4, 5, 6, 13 | Elektroden |
| 5a, 5b | segmentförmige Elektroden |
| 7 | Elektrodenabdeckung |
| 8 | Messleitungen |
| 9 | Ummantelung |
| 10 | Wasser, leitfähiges Medium |
| 11 | Öl, isolierendes (weniger leitfähiges) Medium |
| 12 | Grenzschicht |
| 14 | Schmutzfilm |
| 15 | Oberfläche der Messsonde |
| $a$ | Elektrodenabstand |
| $h$ | Elektrodenhöhe |
| $d_e, d_1, d_2, d_j, d_{j+1}, d_{j+2}$ | Dicke der Elektrodenabdeckung |
| $d_s$ | Dicke eines dielektrischen Schmutzfilms |
| $b_c$ | Dicke eines leitfähigen Schmutzfilms |
| $f$ | Frequenz der Kapazitätsmessung |
| $f_1, f_2$ | Grenzfrequenzen der dielektrischen Relaxation der Medien 10, 11 |
| $f_c$ | Grenzfrequenz der dielektrischen Relaxation des Schmutzfilms |
| $r$ | Radius der Messsonde |
| $z$ | Füllstandshöhe, Ortskoordinate einer Grenzschicht |
| $\varepsilon_0$ | Influenzkonstante |
| $\varepsilon_M$ | Dielektrizitätskonstante eines Mediums |
| $\varepsilon_e$ | Dielektrizitätskonstante der Elektrodenabdeckung |

| | |
|---|---|
| $\varepsilon_s$ | Dielektrizitätskonstante des Schmutzfilms |
| $\rho f$ | spezifischer Widerstand des Schmutzfilms |
| $\rho M$ | spezifischer Widerstand eines Mediums |
| $\tau, \tau_1, \tau_2$ | dielektrische Relaxationszeitkonstanten eines Mediums |
| $\tau_f, \tau_{f0}$ | dielektrische Relaxationszeitkonstante des Schmutzfilms |
| $\omega$ | Kreisfrequenz der Kapazitätsmessung |
| $A, A_j, A_{j+1}$ | Doppelschicht - Kondensatorflächen |
| $B$ | Sondenachse |
| $C_{DS}, C_{DS1}, C_{DS2}$ | Doppelschichtkapazitäten |
| $C_{DSf}$ | Doppelschichtkapazität eines leitfähigen Schmutzfilms |
| $C_\varepsilon$ | Elektrodenpaar - Kapazität für ein isolierendes Medium |
| $C_\sigma, C_{\sigma S}$ | Elektrodenpaar - Kapazität für ein leitfähiges Medium |
| $C(z), C$ | Gesamtkapazität, Elektrodenpaar - Kapazität |
| $G$ | Geometriefaktor |
| $R, R_{ij}, R_{ik}, R_{jk}$ | Widerstände im leitfähigen Medium |

**Patentansprüche**

1. Kapazitiver Füllstandssensor, insbesondere geeignet zur Ortsbestimmung einer Grenzschicht (12) zwischen Wasser (10) und Öl (11) in einem Separatortank, umfassend eine stabförmige Sonde (1) mit mehreren, entlang einer Sondenachse (B) angeordneten Elektroden (4, 5, 6, 13), zwischen denen füllstandsabhängige Kapazitäten gemessen werden, wobei die Elektroden (4, 5, 6, 13) mit einer elektrisch isolierenden Abdeckung (7) versehen sind, **dadurch gekennzeichnet, dass** ein Verhältnis einer Elektrodenhöhe (h) zu einem Elektrodenabstand (a) grösser als eins gewählt ist, wobei die Elektrodenhöhe (h) die Breite einer Elektrode (4, 5, 6, 13) in Richtung einer Achse der Sonde (1) und der Elektrodenabstand der Abstand (a) zwischen benachbarten Kanten zweier nacheinander folgenden Elektroden (4, 5, 6, 13) ist.

2. Kapazitiver Füllstandssensor nach Anspruch 1, **dadurch gekennzeichnet, dass** das Verhältnis von Höhe (h) zu Abstand (a) der Elektroden (4, 5, 6, 13) im Bereich von 1 bis 6, vorzugsweise zwischen 1,5 und 4,5, insbesondere gleich 3, gewählt ist.

3. Kapazitiver Füllstandssensor nach Anspruch 2, **dadurch gekennzeichnet, dass**

   a) die Abdeckung (7) eine Dicke (d,) kleiner als 2,5 mm, bevorzugt kleiner als 1,5 mm, insbesondere kleiner als 1 mm, aufweist und
   b) die Abdeckung (7) eine Dielektrizitätskonstante ($\varepsilon_e$) kleiner als 10, insbesondere kleiner als 5, aufweist.

4. Kapazitiver Füllstandssensor nach einem der Ansprüche 1 - 3, **dadurch gekennzeichnet, dass** die Sonde (1) Elektroden (4, 5, 6, 13) mit Abdeckungen (7) unterschiedlicher Dicken ($d_j$) aufweist.

5. Kapazitiver Füllstandssensor nach Anspruch 4, **dadurch gekennzeichnet, dass**

   a) die Elektroden (4, 5, 6, 13) gleiche Doppelschicht - Kondensatorflächen aufweisen,

b) benachbarte Elektroden (13, 4; 4, 5; 5, 6) unterschiedliche Dicken und übernächst benachbarte Elektroden (13, 5; 4, 6) gleiche Dicken der Abdeckung (7) aufweisen und

c) eine effektive Dicke ($d_s / \varepsilon_s$) eines isolierenden Schmutzfilms (14) gemäss $d_s/\varepsilon_s = (d_i/\varepsilon_e) \cdot [(C_{DSj} \cdot d_j)/(C_{DSi} \cdot d_i) \cdot 1]/[1 - C_{DSj}/C_{DSi}]$ bestimmbar ist, wobei $\varepsilon_e$ = Dielektrizitätskonstante der Abdeckungen (7), und $d_i$, $d_j$ = Dicken der Abdeckung (7) und $C_{DSi}$, $C_{DSj}$ = Doppelschichtkapazitäten einer i - ten, j- ten Elektrode (4, 5).

**6.** Kapazitiver Füllstandssensor nach Anspruch 5, **dadurch gekennzeichnet, dass**

a) die Sonde (1) im wesentlichen aus einem zylindrischen Rohr (2) besteht, an dessen Mantelfläche (2b) die Elektroden (4, 5, 6, 13) aufgebracht sind und

b) das Rohrinnere (3) gegenüber dem die Sonde (1) umgebenden Aussenraum abgeschlossen ist.

**7.** Kapazitiver Füllstandssensor nach Anspruch 6, **dadurch gekennzeichnet, dass**

a) das Rohr (2) kreiszylindrisch ist und

b) die Elektroden (4, 5, 6) ringförmig oder segmentförmig sind und insbesondere im abgerollten Zustand eine rechteckige Form aufweisen.

**8.** Kapazitiver Füllstandssensor nach Anspruch 7, **dadurch gekennzeichnet, dass**

a) das Rohr (2b) aus einem Dielektrikum, insbesondere aus Kunststoff, Glas oder einer Keramik, besteht und

b) die Abdeckung (7) der Elektroden aus Epoxydharz, Glas, einer Keramik oder Glimmer besteht und insbesondere faserverstärkt ist.

**Claims**

**1.** Capacitive liquid level sensor, suitable in particular for determining the location of a boundary layer (12) between water (10) and oil (11) in a separator tank, comprising a rod-shaped probe (1) having a plurality of electrodes (4, 5, 6, 13) arranged along a probe axis (B), between which capacitances dependent on liquid level are measured, the electrodes (4, 5, 6, 13) being provided with an electrically insulating cover (7), **characterized in that** a ratio of an electrode height (h) to an electrode spacing (a) is selected to be greater than one, the electrode height (h) being the width of an electrode (4, 5, 6, 13) in the direction of an axis of a probe (1), and the electrode spacing being the spacing (a) between neighbouring edges of two electrodes (4, 5, 6, 13) following one another.

**2.** Capacitive liquid level sensor according to Claim 1, **characterized in that** the ratio of the height (h) to the spacing (a) of the electrodes (4, 5, 6, 13) is selected to be in the range of 1 to 6, preferably between 1.5 and 4.5, in particular to be equal to 3.

**3.** Capacitive liquid level sensor according to Claim 2, **characterized in that**

a) the cover (7) has a thickness ($d_e$) of less than 2.5 mm, preferably less than 1.5 mm, in particular less than 1 mm, and

b) the cover (7) has a dielectric constant ($\varepsilon_e$) of less than 10, in particular less than 5.

**4.** Capacitive liquid level sensor according to one of Claims 1-3, **characterized in that** the probe (1) has electrodes (4, 5, 6, 13) with covers (7) of different thicknesses ($d_j$).

**5.** Capacitive liquid level sensor according to Claim 4, **characterized in that**

a) the electrodes (4, 5, 6, 13) have identical double-layer capacitor surfaces,

b) neighbouring electrodes (13, 4; 4, 5; 5, 6) have different thicknesses of the cover (7), and electrodes (13, 5; 4, 6) which are next but one relative to each other have identical thicknesses of the cover (7) and

c) an effective thickness ($d_s/\varepsilon_s$) of an insulating dirt film (14) can be determined in accordance with $d_s/\varepsilon_s = (d_i / \varepsilon_e) \cdot [(C_{DSj} \cdot d_j)/(C_{DSi} \cdot d_i) -1]/(1 - C_{DSj}/C_{DSi}]$, where $\varepsilon_e$ = dielectric constant of the covers (7), and $d_i$, $d_j$ = thicknesses of the cover (7) and $C_{DSi}$, $C_{DSj}$ = double-layer capacitors of an i-th, j-th electrode (4, 5).

**6.** Capacitive liquid level sensor according to Claim 5, **characterized in that**

a) the probe (1) essentially comprises a cylindrical tube (2) on whose lateral surface (2b) the electrodes (4, 5, 6, 13) are mounted, and

b) the tube interior (3) is sealed with respect to the outside surrounding the probe (1).

**7.** Capacitive liquid level sensor according to Claim 6, **characterized in that**

a) the tube (2) is a circular cylinder, and

b) the electrodes (4, 5, 6) are in the shape of a ring or segment and, in particular, have a rectangular shape in the rolled-out state.

**8.** Capacitive liquid level sensor according to Claim 7, **characterized in that**

a) the tube (2b) consists of a dielectric, in particular of plastic, glass or a ceramic, and

b) the cover (7) of electrodes consists of epoxy resin, glass or ceramic or mica and is, in particular, fibre-reinforced.

## Revendications

**1.** Détecteur de niveau capacitif, particulièrement adapté pour la localisation d'une couche de délimitation (12) entre l'eau (10) et l'huile (11) dans un réservoir séparateur, comprenant une sonde en forme de tige (1) munie de plusieurs électrodes (4, 5, 6, 13) disposées le long d'un axe de la sonde (B) entre lesquelles sont mesurées des capacités dépendantes du niveau de remplissage, les électrodes (4, 5, 6, 13) étant munies d'un revêtement (7) isolant électrique, **caractérisé en ce que** le rapport choisi entre une hauteur d'électrode (h) et un écart entre électrodes (a) est supérieur à un, la hauteur d'électrode (h) étant égale à la largeur d'une électrode (4, 5, 6, 13) en direction d'un axe de la sonde (1) et l'écart entre électrodes étant égal à l'écart (a) entre deux bords voisins de deux électrodes successives (4, 5, 6, 13).

**2.** Détecteur de niveau capacitif selon la revendication 1, **caractérisé en ce que** le rapport choisi entre la hauteur (h) et l'écart (a) des électrodes (4, 5, 6, 13) est compris entre 1 et 6, de préférence entre 1,5 et 4,5, plus particulièrement égal à 3.

**3.** Détecteur de niveau capacitif selon la revendication 2, **caractérisé en ce que**

a) le revêtement (7) présente une épaisseur ($d_e$) inférieure à 2,5 mm, de préférence inférieure à 1,5 mm, plus particulièrement inférieure à 1 mm et

b) le revêtement (7) présente une constante diélectrique ($s_e$) inférieure à 10, plus particulièrement inférieure à 5.

**4.** Détecteur de niveau capacitif selon l'une des revendications 1 à 3, **caractérisé en ce que** la sonde (1) présente des électrodes (4, 5, 6, 13) ayant des revêtements (7) d'épaisseurs ($d_i$) différentes.

**5.** Détecteur de niveau capacitif selon la revendication 4, **caractérisé en ce que**

a) les électrodes (4, 5, 6, 13) présentent les mêmes surfaces de condensateur à double couche,

b) les électrodes voisines (13, 4 ; 4, 5 ; 5, 6) présentent des épaisseurs différentes et les électrodes alternées (13, 5 ; 4, 6) présentent les mêmes épaisseurs du revêtement (7) et

c) il est possible de définir une épaisseur efficace ($d_s/\varepsilon_s$) d'un film de saleté isolant (14) selon $d_s/\varepsilon_s = (d_i/\varepsilon_s)$ * $[(C_{DSj} * d_j)/(C_{DSi} * d_i) - 1]/[1 - C_{DSj}/C_{DSi}]$, $\varepsilon_e$ désignant la constante diélectrique des revêtements (7) et $d_i$, $d_j$ les épaisseurs du revêtement (7) et $C_{DSj}$, $C_{DSj}$ les capacités à double couche d'une i-ième, j-ième électrode (4, 5).

**6.** Détecteur de niveau capacitif selon la revendication 5, **caractérisé en ce que**

a) la sonde (1) se compose pour l'essentiel d'un tube cylindrique (2) sur la surface d'enveloppe (2b) duquel sont fixées les électrodes (4, 5, 6, 13) et

b) l'intérieur du tube (3) est fermé par rapport à l'espace qui entoure la sonde (1).

**7.** Détecteur de niveau capacitif selon la revendication 6, **caractérisé en ce que**

a) le tube (2) est cylindrique circulaire et
b) les électrodes (4, 5, 6) sont en forme d'anneaux ou en forme de segments et présentent plus particulièrement une forme rectangulaire en position déroulée.

**8.** Détecteur de niveau capacitif selon la revendication 7, **caractérisé en ce que**

a) le tube (2b) se compose d'un matériau diélectrique, plus particulièrement du plastique, du verre ou de la céramique et
b) le revêtement (7) des électrodes se compose de résine époxy, de verre, de céramique ou de mica et plus particulièrement qu'il est renforcé avec des fibres.

Figur 1

Figur 2

Fig. 3

Fig. 4

Figur 5

Figur 6a

Figur 6b